# EUROPEAN PATENT APPLICATION

(11) **EP 4 471 605 A1**
(43) Date of publication of application: **04.12.2024**
(21) Application number: 22922024.9
(22) Date of filing: 27.10.2022
(51) Int. Cl.: G06F 12/06

(54) **STORAGE MEDIUM MODULE**

(30) Priority: 24.01.2022 JP 2022008769
(71) Applicant: Panasonic Intellectual Property Management Co., Ltd., Kadoma-shi, Osaka 571-0057 (JP)
(72) Inventor: TOBINAGA, Masato, Kadoma-shi, Osaka 571-0057 (JP); IIZUKA, Mitsuhiro, Kadoma-shi, Osaka 571-0057 (JP); TORII, Munehiro, Kadoma-shi, Osaka 571-0057 (JP); TAKEDA, Kazuhiro, Kadoma-shi, Osaka 571-0057 (JP); MAKI, Noriyuki, Kadoma-shi, Osaka 571-0057 (JP)
(74) Representative: Grünecker Patent- und Rechtsanwälte PartG mbB
(86) International application number: PCT/JP2022/040120
(87) International publication number: WO 2023/139872

(57) **Abstract**

A storage medium module of the present disclosure includes: a board having a first surface and a second surface opposite to the first surface; a first connector mounted on the first surface of the board and detachably connected to an electronic device; and a second connector mounted on the first surface separately from the first connector in a longitudinal direction of the board and connected with a storage medium. The board includes a first part extending between the first connector and the second connector and having flexibility, and the first part is formed with curvature.

## Description

### TECHNICAL FIELD

The present disclosure relates to a storage medium module.

### BACKGROUND ART

Some storage media such as a solid state drive (SSD) and a hard disk (HDD) in which various information is recorded are built in an electronic device. For example, PTL 1 discloses a memory unit equipped with a memory card or the like and built in a portable device.

### Citation List

### Patent Literature

PTL 1: Unexamined Japanese Patent Publication No. 2003-288565

### SUMMARY OF THE INVENTION

In recent years, a storage medium module including a recording medium recording such information has been required to be able to be not only detachably attached to an electronic device but also prevented from being damaged.

It is thus an object of the present disclosure to provide a storage medium module that can be not only detachably attached to an electronic device but also prevented from being damaged.

A storage medium module according to the present disclosure includes: a board having a first surface and a second surface opposite to the first surface; a first connector mounted on the first surface of the board and detachably connected to an electronic device; and a second connector mounted on the first surface separately from the first connector in a longitudinal direction of the board and connected with a storage medium. The board includes a first part extending between the first connector and the second connector and having flexibility, and the first part is formed with curvature.

The storage medium module according to an exemplary embodiment of the present disclosure enables providing a storage medium module that can be not only detachably attached to an electronic device but also prevented from being damaged.

### BRIEF DESCRIPTION OF THE DRAWINGS

Fig. 1 is a schematic perspective view of an electronic device to which a storage medium module according to an exemplary embodiment of the present disclosure is attached.
Fig. 2 is a schematic perspective view illustrating a state in which a storage medium module is housed in a module storage part in the electronic device illustrated in Fig. 1.
Fig. 3 is an enlarged view of the module storage part of the electronic device illustrated in Fig. 1.
Fig. 4 is a schematic perspective view of a storage medium module according to an exemplary embodiment of the present disclosure.
Fig. 5 is a schematic exploded view of the storage medium module illustrated in Fig. 4.
Fig. 6 is a schematic upper perspective view of the storage medium module illustrated in Fig. 4, in which a module housing is removed.
Fig. 7 is a schematic side view of the storage medium module illustrated in Fig. 4, in which the module housing is removed.
Fig. 8 is an enlarged view of a part of Fig. 7.
Fig. 9 is a schematic lower perspective view of the storage medium module illustrated in Fig. 4, in which the module housing is removed.
Fig. 10 is a diagram illustrating operation of the storage medium module illustrated in Fig. 4 when the storage medium module is attached to an electronic device.

### DESCRIPTION OF EMBODIMENT

### (Background to present disclosure)

In recent years, a storage medium recording confidential information has been required to be handled more safely. Thus, electronic devices with built-in storage media are each required to be safely stored. However, the storage for each electronic device causes problems such as requiring a large storage space, and prohibiting taking out of the electronic device to the outside of a company.

Thus, the inventors have conceived of allowing a storage medium module with a storage medium attached to be detachable from the electronic device to manage the storage medium separately from the electronic device. Already used examples of the storage medium module detachably attached to an electronic device include a storage medium module that is externally connected to an electronic device by a method using a connection cable such as a USB. However, externally connecting a module using a USB or the like is not suitable for an electronic device requiring waterproof and dust-proof properties. Thus, the inventors have studied a storage medium module that can be detachably housed in an electronic device.

The inventors have also found an additional problem in development of such a storage medium module that can be detachably housed in an electronic device, the additional problem showing that the storage medium module is damaged by an impact of insertion and removal of a connector of the storage medium module when the storage medium module is attached to or detached from the electronic device.

As a result of intensive studies to solve these problems, the inventors have found a storage medium module that can be detachably attached in an electronic device and has a configuration capable of preventing from being damaged, thereby having reached the present disclosure.

A storage medium module of a first aspect of the present disclosure includes: a board including a first surface and a second surface opposite to the first surface; a first connector mounted on the first surface of the board and detachably connected to an electronic device; and a second connector mounted on the first surface separately from the first connector in a longitudinal direction of the board and connected to a storage medium, the board including a first part extending between the first connector and the second connector and having flexibility, and the first part being curved.

Such a configuration enables the storage medium to be removed from the electronic device and managed separately from the electronic device. Such a configuration also enables the first part to partly absorb a force that is externally loaded on the storage medium module. As a result, the force is partly transmitted to the second connector or the storage medium module while being reduced.

A storage medium module of a second aspect of the present disclosure may further include a buffer member disposed on the second surface and at a position overlapping the second connector when viewed from a thickness direction of the board.

Such a configuration allows the buffer member to partly absorb a force applied from the second surface to the second connector in the thickness direction. As a result, the force is partly transmitted to the second connector or the storage medium module while being reduced.

A storage medium module of a third aspect of the present disclosure may be configured as follows: the board includes one end in the longitudinal direction and the other end opposite to the one end; the first connector and the second connector are disposed apart from the one end and the other end; the second connector is disposed at a position closer to the other end than the first connector; the board includes a second part extending between the one end and the first connector and is bent with the second surface facing inward between the one end and the second connector; at least a part of the first part and at least a part of the second part are disposed at respective positions overlapping each other as viewed in the thickness direction of the board; and the buffer member is disposed on the second surface of the second part.

Such a configuration allows the first part and the buffer member to partly absorb force loaded from the outside of the storage medium module. As a result, the force is partly transmitted to the second connector or the storage medium module while being reduced.

A storage medium module of a fourth aspect of the present disclosure may be configured such that the first surface of the first part is provided with wiring for transmitting a high-speed signal.

Such a configuration enables a transmission distance of the high-speed signal to be shortened to enable securing high transmission performance of the high-speed signal.

A storage medium module of the fifth aspect of the present disclosure may be configured such that the first connector includes a low-speed signal pin and a high-speed signal pin disposed at a position closer to the second connector than the low-speed signal pin.

Such a configuration enables a transmission distance of the high-speed signal to be shortened to enable securing high transmission performance of the high-speed signal.

A storage medium module of a sixth aspect of the present disclosure may be configured such that the board is a flexible printed circuit board, and the storage medium module includes a reinforcement plate disposed on the second surface at a position overlapping the storage medium and the second connector when viewed from the thickness direction of the board.

Such a configuration allows the second connector and the storage medium to be stably held.

A storage medium module of a seventh aspect of the present disclosure may be configured such that the longitudinal direction of the board is a direction in which the storage medium module is detachable from the electronic device, and the first part is curved in the thickness direction of the board.

Such a configuration enables the first part to partly absorb force loaded on the storage medium module through the first connector when the storage medium module is attached to or detached from the electronic device, for example. As a result, the force is partly transmitted to the second connector or the storage medium module while being reduced.

A storage medium module of an eighth aspect of the present disclosure may be configured such that the first part includes a first curved part curved in a direction from the second surface toward the first surface, a second curved part connected to the first curved part and curved in a direction from the second connector toward the first connector, and a third curved part connected to the second curved part and curved in a direction from the first surface toward the second surface.

Such a configuration enables the first part to partly absorb a force that is externally loaded on the storage medium module. As a result, the force is partly transmitted to the second connector or the storage medium module while being reduced.

A storage medium module according to a ninth aspect of the present disclosure may include a module housing that supports the board.

Such a configuration allows the board to be supported by the module housing, and enables the storage medium module to be easily detachable from the electronic device.

An electronic device of a tenth aspect of the present disclosure may include the storage medium module described in any one of the first to tenth aspects.

Such a configuration enables the storage medium to be stored separately from the electronic device. Such a configuration also enables a plurality of electronic devices to share information using the storage medium module. Additionally, such a configuration enables one electronic device to process data stored in each of a plurality of storage media.

Hereinafter, an exemplary embodiment of the present disclosure will be described with reference to the accompanying drawings. Each drawing illustrates each element in an exaggerated manner to facilitate description.

The terms "first", "second", and the like herein are only used for description, and should not be understood as explicitly or implicitly indicating relative importance or a rank of a technical feature. Features limited to "first" and "second" are intended to explicitly or implicitly indicate inclusion of one or more such features.

Directions X1, Y1, Z1 in each accompanying drawing respectively indicate a width direction, a depth direction, and a height direction of electronic device 1. Directions X2, Y2, Z2 in each accompanying drawing respectively indicate a longitudinal direction, a lateral direction, and a thickness direction of storage medium module 100, module housing 20, and board 50.

### (First exemplary embodiment)

### (General configuration of electronic device)

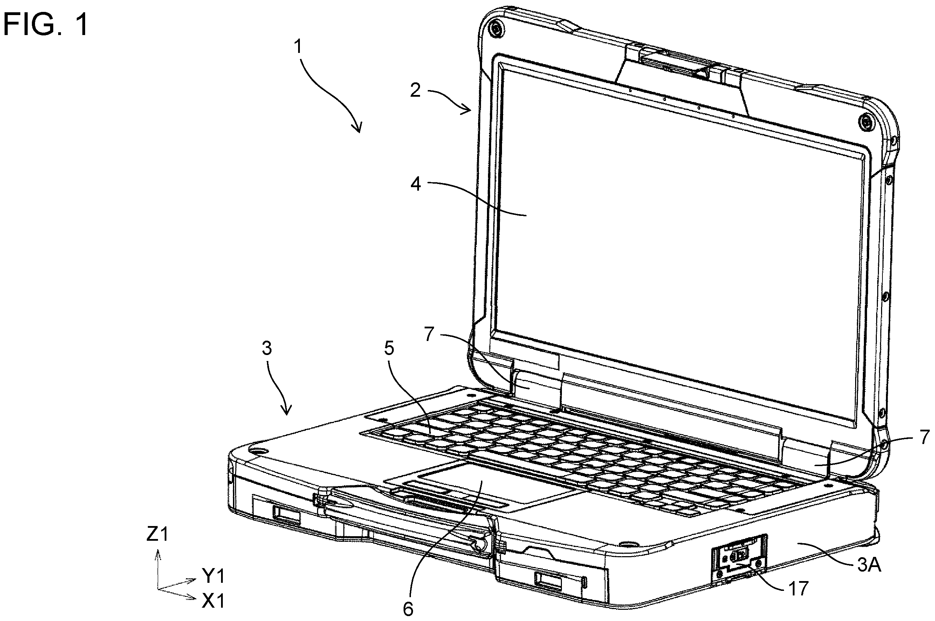

Fig. 1 is a schematic perspective view of electronic device 1 to which storage medium module 100 according to an exemplary embodiment of the present disclosure is attached. As illustrated in Fig. 1, electronic device 1 is a notebook personal computer (laptop PC). Electronic device 1 includes first housing 2 and second housing 3. Each of first housing 2 and second housing 3 has a thin box-shaped outer contour and has a rectangular shape.

As illustrated in Fig. 1, first housing 2 and second housing 3 are connected using hinge part 7. Hinge part 7 rotatably connects first housing 2 and second housing 3. Hinge part 7 allows first housing 2 and/or second housing 3 to rotate and electronic device 1 to be brought into an open state or a closed state. The "open state" means a state in which first housing 2 and second housing 3 are separated, and display 4 and input interfaces 5, 6 are exposed. The "closed state" means a state in which first housing 2 and second housing 3 are disposed facing each other, display 4 and input interfaces 5, 6 face each other, and display 4 and input interfaces 5, 6 are not exposed.

First housing 2 and second housing 3 are each made of a metal material. For example, first housing 2 and second housing 3 are each made of magnesium alloy.

### (First housing)

First housing 2 houses display 4. Display 4 is a liquid crystal, for example. Display 4 includes a display surface exposed from first housing 2. First housing 2 houses a camera, an antenna, and the like.

### (Second housing)

Second housing 3 houses input interfaces. The input interfaces are keyboard 5 and touch pad 6, for example. The input interfaces are exposed from a surface of second housing 3. Keyboard 5 and touch pad 6 herein may be referred to as input interfaces 5, 6. Second housing 3 internally houses a circuit such as a CPU and a memory.

Surfaces of second housing 3 includes a surface on which the input interfaces are exposed, the surface herein being also referred to as upper surface of second housing 3. The surfaces of second housing 3 includes a surface opposite to the upper surface, the surface being also referred to as a lower surface of second housing 3. The upper surface and the lower surface are connected by surfaces that are also referred to as side surfaces 3A of second housing 3. Side surfaces 3A of second housing 3 includes a surface on a side connected to first housing 2, the surface being is also referred to as a back surface of second housing 3, and a surface opposite to the back surface is also referred to as a front surface of second housing 3.

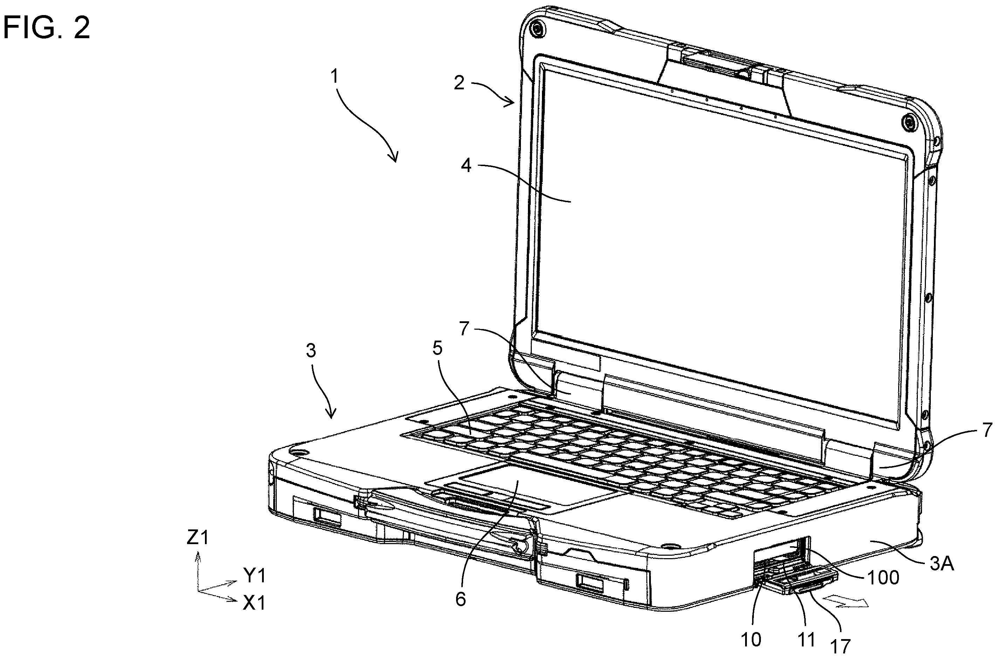

Fig. 2 is a schematic perspective view illustrating a state in which storage medium module 100 is housed in module storage part 10. As illustrated in Fig. 2, second housing 3 further includes module storage part 10 that houses storage medium module 100. Fig. 2 illustrates an outlined arrow along direction X1, the outlined arrow indicating a direction in which storage medium module 100 is taken out from electronic device 1. Module storage part 10 in the present exemplary embodiment is provided in side surface 3A of second housing 3, for example.

### (Module storage part)

As illustrated in Fig. 2, module storage part 10 includes opening 11 for attaching and detaching storage medium module 100, and lid part 17 for opening and closing opening 11. Opening 11 is provided in side surface 3A of second housing 3, for example. Lid part 17 is connected to second housing 3 using a hinge, for example.

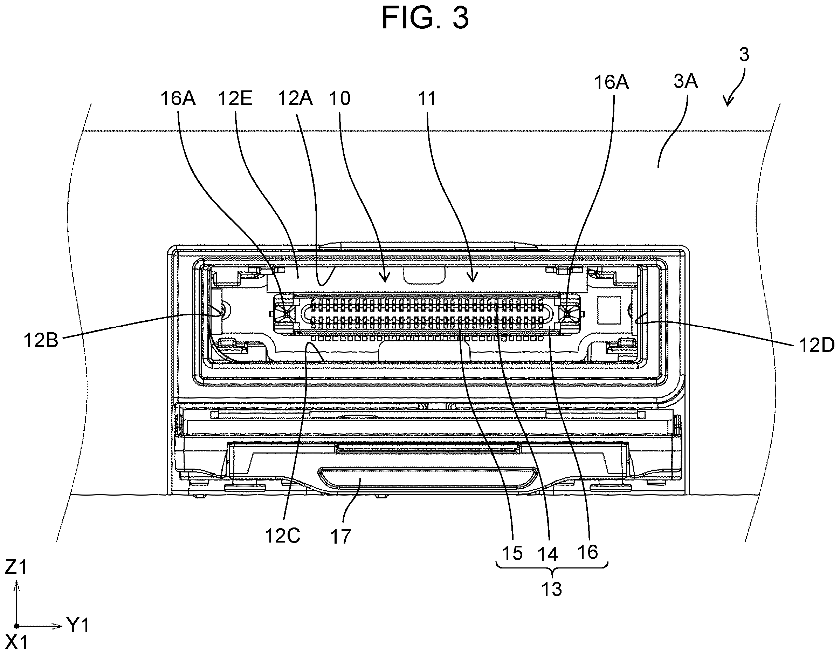

Fig. 3 is an enlarged view of module storage part 10. As illustrated in Fig. 3, module storage part 10 is defined by inner walls of second housing 3. The inner walls defining module storage part 10 includes first inner wall 12A, second inner wall 12B, third inner wall 12C, fourth inner wall 12D, and fifth inner wall 12E, for example. First inner wall 12A is an inner wall close to the upper surface of second housing 3. Third inner wall 12C is an inner wall that faces first inner wall 12A and is close to the lower surface of second housing 3. Second inner wall 12B is an inner wall close to the front surface of second housing 3. Fourth inner wall 12D is an inner wall that faces second inner wall 12B and is close to the back surface of second housing 3. Fifth inner wall 12E is an innermost inner wall of second housing 3 as viewed from opening 11. Two inner walls "facing" herein means that the two inner walls are disposed facing each other, and the two inner walls are not limited to be disposed parallel to each other.

More specifically, each of first inner wall 12A to fourth inner wall 12D has one end close to side surface 3A of second housing 3 and the other end far from side surface 3A of second housing 3 in direction X1, and extends in direction X1. Fifth inner wall 12E extends in direction Y1. Module storage part 10 has a section taken along line Y1-Z1 in which first inner wall 12A to fourth inner wall 12D form a substantially rectangular shape.

Module storage part 10 may include a member other than the inner walls of second housing 3. First inner wall 12A to fifth inner wall 12E are not limited to flat surfaces, and may include steps, irregularities, and the like.

As illustrated in Fig. 3, module storage part 10 includes module connection terminal 13. Module connection terminal 13 is connected to first connector 30 of storage medium module 100 when storage medium module 100 is housed in module storage part 10.

Module connection terminal 13 includes high-speed signal terminal 14, low-speed signal terminal 15, and first support member 16. The high-speed signal is a signal of 5 Gbps (2.5 GHz) or more, for example. The high-speed signal is a signal such as PCI Express, USB, or HDMI (registered trademark), for example. The low-speed signal is a signal that is slower than the high-speed signal and is less than 5 Gbps (2.5 GHz), for example. The low-speed signal is a signal such as I2C or an SSD detection signal, for example. Module connection terminal 13 is disposed on fifth inner wall 12E, for example.

First support member 16 supports high-speed signal terminal 14 and low-speed signal terminal 15. First support member 16 extends in depth direction Y1. First support member 16 is provided at opposite ends in depth direction Y1 with respective first guide parts 16A. First guide part 16A serves to guide storage medium module 100 when storage medium module 100 is attached to or detached from module storage part 10.

First guide part 16A protrudes in width direction X1 from fifth inner wall 12E toward opening 11, for example. First guide part 16A is a pin, for example. First guide part 16A has a columnar shape such as a quadrangular prism, for example. First guide part 16A may have a sharp tip.

High-speed signal terminal 14 and low-speed signal terminal 15 are provided on fifth inner wall 12E, for example. High-speed signal terminal 14 is provided above low-speed signal terminal 15.

Each of high-speed signal terminal 14 and low-speed signal terminal 15 may include a plurality of pins. In this case, the plurality of pins of high-speed signal terminal 14 and the plurality of pins of low-speed signal terminal 15 are disposed at equal intervals in depth direction Y1, for example. The plurality of pins of high-speed signal terminal 14 is provided above the plurality of pins of low-speed signal terminal 15.

### (Storage medium module)

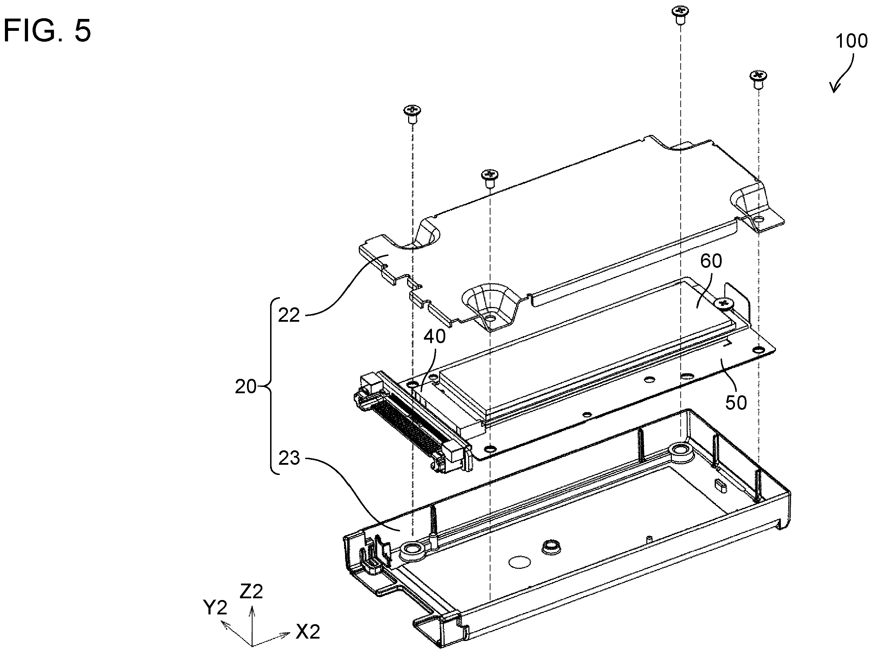

Fig. 5 is a schematic exploded view of storage medium module 100. As illustrated in Fig. 5, storage medium module 100 includes module housing 20 and board 50 that is enclosed and supported in module housing 20. Board 50 is equipped with first connector 30 and second connector 40.

Storage medium module 100 has a substantially rectangular parallelepiped shape having sides in longitudinal direction X2, lateral direction Y2, and thickness direction Z2. Storage medium module 100 is attached to or detached from electronic device 1 with longitudinal direction X2 aligned with width direction X1 of electronic device 1. That is, longitudinal direction X2 of storage medium module 100 is a direction in which storage medium module 100 is detachable from electronic device 1.

Although a form is described in the first exemplary embodiment, in which longitudinal direction X2 of storage medium module 100 is the direction in which storage medium module 100 is detachable from electronic device 1, the present invention is not limited thereto. For example, a storage medium module according to the present disclosure may have a shape in which the longitudinal direction and the lateral direction are opposite in the storage medium module according to the first exemplary embodiment.

### (Module housing)

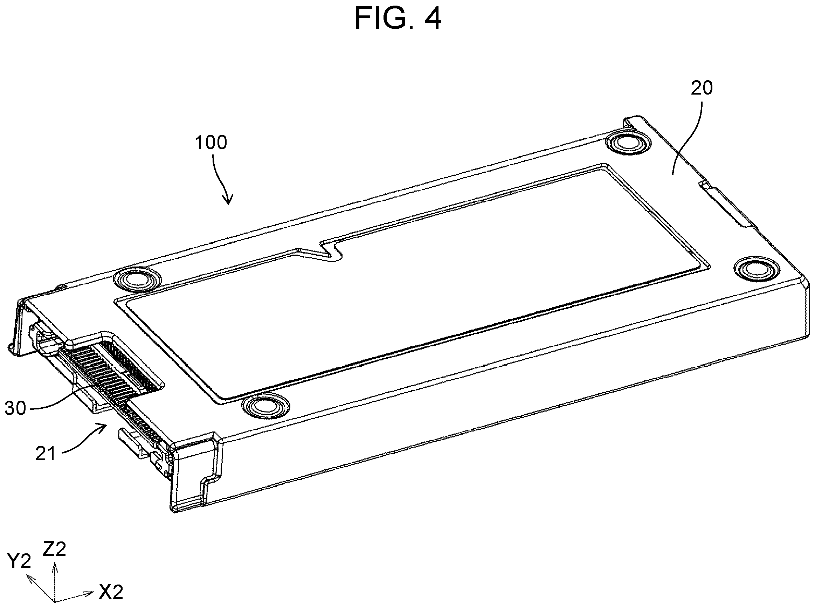

Fig. 4 is a schematic perspective view of storage medium module 100. As illustrated in Fig. 4, module housing 20 defines an outline of storage medium module 100. Module housing 20 has a substantially rectangular parallelepiped shape having sides in longitudinal direction X2, lateral direction Y2, and thickness direction Z2 that are respectively identical to longitudinal direction X2, lateral direction Y2, and thickness direction Z2 of storage medium module 100. Module housing 20 is provided at one end in longitudinal direction X2 with opening 21. Opening 21 exposes first connector 30.

As illustrated in Fig. 5, module housing 20 may include first module housing 22 and second module housing 23, and enclose board 50 interposed between first module housing 22 and second module housing 23, for example. First module housing 22 and second module housing 23 in this case are fixed to each other with a screw or the like with board 50 interposed therebetween, for example.

As a material of module housing 20, a magnesium alloy is used, for example.

### (Board)

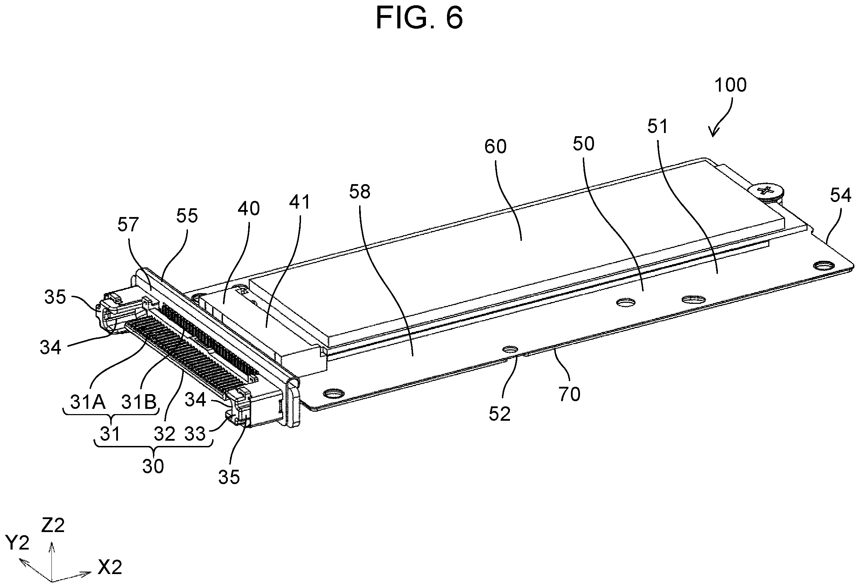

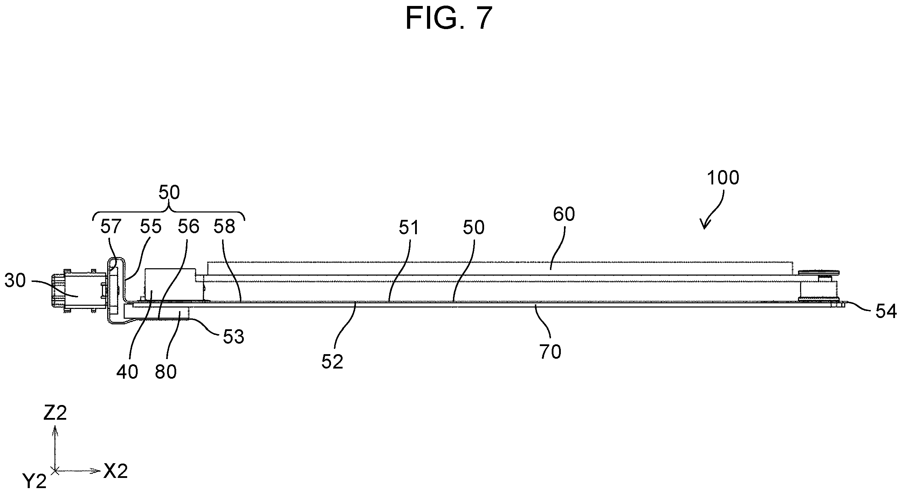

Fig. 6 is a schematic upper perspective view of storage medium module 100, in which module housing 20 is removed. Fig. 7 is a schematic side view of storage medium module 100, in which module housing 20 is removed. As illustrated in Figs. 6 and 7, board 50 is a thin plate-like member. Board 50 is equipped with first connector 30 and second connector 40 that are away from each other. Board 50 includes first part 55 extending between first connector 30 and second connector 40. First part 55 has flexibility. Although board 50 may be entirely formed of a flexible member, a part other than first part 55 in this case has rigidity using a reinforcement plate, for example. Board 50 is a flexible printed circuit board, for example.

Board 50 includes first surface 51 and second surface 52 located opposite to first surface 51. Board 50 includes sides in longitudinal direction X2, lateral direction Y2, and thickness direction Z2 that are respectively identical to longitudinal direction X2, lateral direction Y2, and thickness direction Z2 of storage medium module 100. Thus, longitudinal direction X2 of board 50 is a direction in which storage medium module 100 is detachable from electronic device 1.

As illustrated in Fig. 7, board 50 includes first end 53 in longitudinal direction X2 and second end 54 located opposite to first end 53 in longitudinal direction X2. Board 50 is bent with second surface 52 facing inward at a position between first end 53 and second end 54, and closer to first end 53 than second end 54. A detailed shape of board 50 will be described later.

As illustrated in Fig. 7, first connector 30 and second connector 40 are mounted on first surface 51 of board 50. First connector 30 and second connector 40 are separated from each other in longitudinal direction X2 of board 50. First connector 30 and second connector 40 are disposed separately from first end 53 and second end 54 of board 50, respectively. Second connector 40 is disposed at a position closer to second end 54 than first connector 30. In other words, first connector 30 and second connector 40 are disposed at a distance from first end 53 and second end 54 of board 50, respectively. Second connector 40 has a distance from first end 53, the distance being longer than a distance from first end 53 to first connector 30. Here, the distance is a length along first surface 51 of board 50.

Board 50 includes second part 56, third part 57, and fourth part 58 in addition to first part 55. Second part 56 extends between first connector 30 and first end 53. Third part 57 connects first part 55 and second part 56, and is equipped with first connector 30. Fourth part 58 is connected to first part 55 and extends between first part 55 and second end 54. Fourth part 58 is equipped with second connector 40. That is, board 50 includes fourth part 58, first part 55, third part 57, and second part 56 in order from second end 54 toward first end 53.

Board 50 is bent with second surface 52 facing inward between first end 53 and second connector 40. At least a part of first part 55 and at least a part of second part 56 are disposed at respective positions overlapping each other as viewed in thickness direction Z2 of board 50.

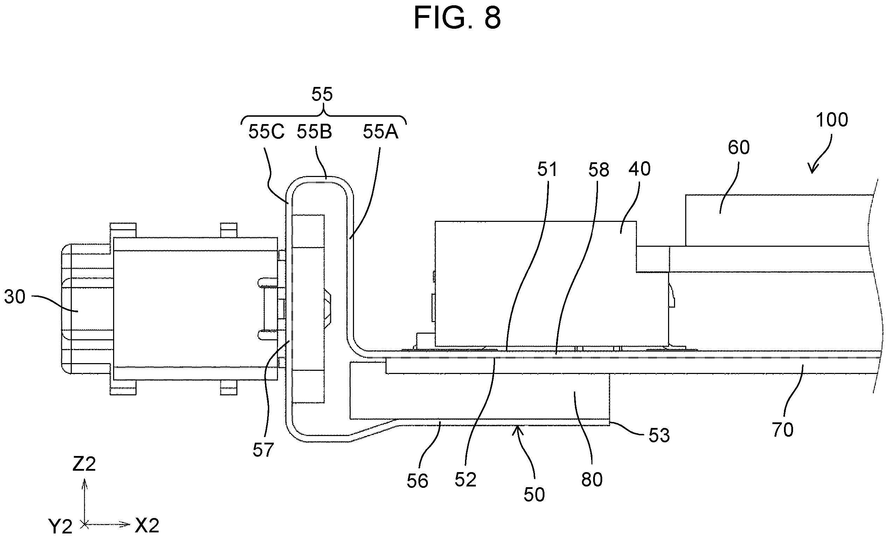

Fig. 8 is an enlarged view of a part of Fig. 7. With reference to Figs. 7 and 8, first part 55 to fourth part 58 will be described in detail in order of proximity to second end 54, and the shape of board 50 will be described in more detail.

As illustrated in Fig. 7, fourth part 58 is connected to second end 54. Fourth part 58 extends in longitudinal direction X2 of board 50. Fourth part 58 is equipped with second connector 40 at a position on first surface 51, the position being close to first part 55.

As illustrated in Fig. 8, first part 55 is connected to fourth part 58. First part 55 is curved in thickness direction Z2. For example, first part 55 is curved in thickness direction Z2 of board 50 from second surface 52 to first surface 51. At least a part of first part 55 may be curved.

First part 55 includes first curved part 55A, second curved part 55B, and third curved part 55C, for example. First curved part 55A is curved in a direction from second surface 52 toward first surface 51. Second curved part 55B is connected to first curved part 55A and is curved in a direction from second connector 40 toward first connector 30. Third curved part 55C is connected to second curved part 55B and is curved in a direction from first surface 51 toward second surface 52.

Third part 57 is connected to first part 55. Third part 57 extends in thickness direction Z2 of board 50, for example. Third part 57 is connected to third curved part 55C of first part 55, for example.

Second part 56 is connected to third part 57. Second part 56 is also connected to first end 53. Second part 56 is curved in a direction from first connector 30 toward second connector 40, for example. Second part 56 further includes a part that extends in length direction X2 of board 50 to be connected to first end 53, for example.

At least a part of second part 56 is disposed at a position overlapping at least a part of first part 55 as viewed in thickness direction Z2 of board 50. At least another part of second part 56 may be disposed at a position overlapping at least a part of fourth part 58 as viewed in thickness direction Z2 of board 50. For example, a part extending in length direction X2 of board 50 is partly disposed at a position overlapping at least a part of fourth part 58 as viewed in thickness direction Z2 of board 50.

### (Wiring provided on board)

Board 50 is provided on first surface 51 and second surface 52 with wiring for transmitting an electric signal between first connector 30 and second connector 40.

Specifically, first surface 51 of first part 55 is provided with wiring for transmitting a high-speed signal. First surface 51 and/or second surface 52 of second part 56 is provided with wiring for transmitting a low-speed signal. The wiring for transmitting a high-speed signal may also be provided on second surface 52 of first part 55. The wiring for transmitting a low-speed signal may also be provided on first surface 51 and/or second surface 52 of first part 55. The wiring for transmitting a low-speed signal may be further provided inside board 50.

The wiring for transmitting a high-speed signal electrically connects first high-speed signal pin 31 of first connector 30 and a second high-speed signal pin of second connector 40. The wiring for transmitting a low-speed signal electrically connects first low-speed signal pin 32 of first connector 30 and a second low-speed signal pin of second connector 40. The wiring for transmitting a high-speed signal has a length from first connector 30 to second connector 40, the length being shorter than a length from first connector 30 to second connector 40 of the wiring for transmitting a low-speed signal.

First surface 51 and/or second surface 52 of third part 57, and first surface 51 and/or second surface 52 of fourth part 58, are also provided with wiring for transmitting a high-speed signal and wiring for transmitting a low-speed signal as appropriate.

### (First connector)

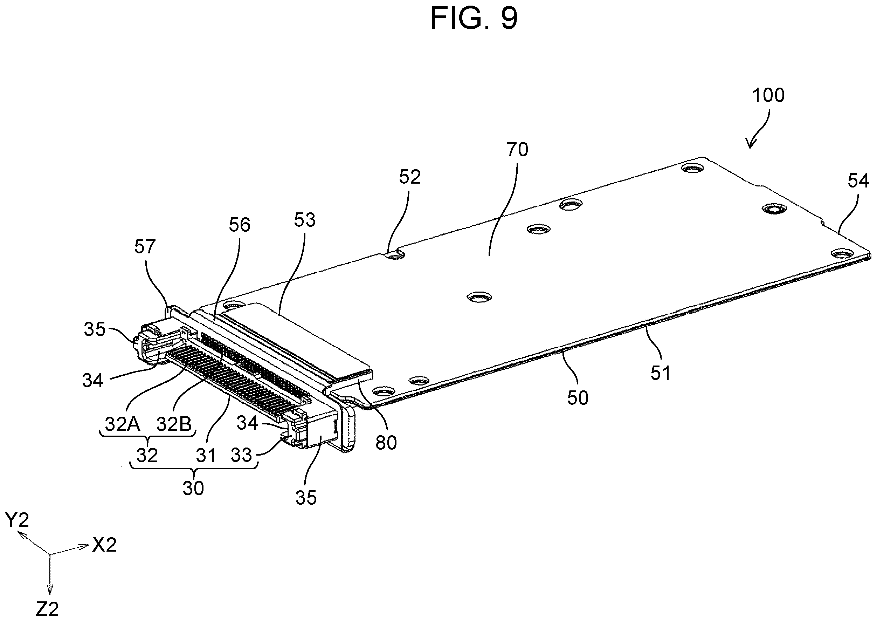

First connector 30 can be detachably connected to module connection terminal 13 of electronic device 1. First connector 30 is connected to module connection terminal 13 when module connection terminal 13 is inserted into first connector 30, for example. Fig. 9 is a schematic lower perspective view of storage medium module 100, in which module housing 20 is removed. As illustrated in Figs. 6 and 9, first connector 30 includes first high-speed signal pin 31, first low-speed signal pin 32, and second support member 33.

Second support member 33 extends in lateral direction Y2 of board 50. Second support member 33 includes protrusions 35 at respective opposite ends in lateral direction Y2 of board 50. Protrusion 35 extends in longitudinal direction X2. Two protrusions 35 includes inner surfaces facing each other that are provided with respective second guide parts 34.

Second guide part 34 is a recess formed inside protrusion 35, for example. Second guide part 34 guides storage medium module 100 when storage medium module 100 is attached to and detached from electronic device 1. Specifically, when storage medium module 100 is attached to or detached from electronic device 1, second guide part 34 houses first guide part 16A of module connection terminal 13 to guide storage medium module 100.

First high-speed signal pin 31 and first low-speed signal pin 32 are mounted on first surface 51 of third part 57. For example, first high-speed signal pin 31 and first low-speed signal pin 32 are disposed between two protrusions 35 of second support member 33. First high-speed signal pin 31 and first low-speed signal pin 32 are connected to high-speed signal terminal 14 and low-speed signal terminal 15 of module connection terminal 13, respectively.

First high-speed signal pin 31 is disposed at a position closer to second connector 40 than first low-speed signal pin 32. This means that first high-speed signal pin 31 has a distance from second connector 40, the distance being shorter than a distance of first low-speed signal pin 32 from second connector 40. Here, the distance is a length along first surface 51 of board 50.

Each of first high-speed signal pin 31 and first low-speed signal pin 32 may constitute a plurality of pins. In this case, the plurality of first high-speed signal pins 31 and the plurality of first low-speed signal pins 32 are arranged at equal intervals in short direction Y2 of board 50, for example. The plurality of first high-speed signal pins 31 is disposed at positions closer to second connector 40 than the plurality of first low-speed signal pins 32. That is, a distance between each of the plurality of first high-speed signal pins 31 and second connector 40 is shorter than a distance between each of the plurality of first low-speed signal pins 32 and second connector 40.

As illustrated in Figs. 6 and 9, the plurality of first high-speed signal pins 31 and the plurality of first low-speed signal pins 32 include contact parts 31A, 32A, respectively, contact parts 31A, 32A coming into contact with module connection terminal 13 of electronic device 1, and mounting parts 31B, 32B continuous with contact parts 31A, 32A, respectively, for example. Mounting parts 31B, 32B are mounted on board 50 by soldering, for example. Each of contact parts 31A, 32A protrudes from first surface 51 of board 50 to extend in longitudinal direction X2 of board 50. Between contact part 31A of first high-speed signal pin 31 and contact part 32A of first low-speed signal pin 32, an insulating member may be interposed to prevent the contact parts from being electrically connected to each other, for example.

### (Second connector)

As illustrated in Fig. 6, second connector 40 includes third support member 41. Third support member 41 includes the second high-speed signal pin (not illustrated) and the second low-speed signal pin (not illustrated). As a material of third support member 41, an insulating material is used.

One end of the second high-speed signal pin and one end of the second low-speed signal pin are mounted on board 50 by soldering, for example, and are electrically connected to the wiring for a high-speed signal or the wiring for a low-speed signal. The other end of the second high-speed signal pin is connected to a high-speed signal terminal (not illustrated) of storage medium 60. The other end of the second low-speed signal pin is connected to a low-speed signal terminal (not illustrated) of storage medium 60.

### (Storage medium)

Storage medium 60 is an SSD or an HDD, for example. Storage medium 60 includes a high-speed signal terminal and a low-speed signal terminal. Storage medium 60 may be connected to second connector 40 in an undetachable manner or may be connected to second connector 40 in a detachable manner.

### (Reinforcement plate)

As illustrated in Fig. 7, reinforcement plate 70 extends along longitudinal direction X2 of board 50. Reinforcement plate 70 is disposed on second surface 52 of board 50 at a position overlapping second connector 40 and storage medium 60 as viewed in thickness direction Z2 of board 50. For example, reinforcement plate 70 is disposed on second surface 52 of fourth part 58 of board 50.

Reinforcement plate 70 may be disposed in a range wider than a range overlapping second connector 40 and storage medium 60 as viewed in thickness direction Z2 of board 50. Reinforcement plate 70 may be disposed in at least a part of the range overlapping second connector 40 and storage medium 60 as viewed in thickness direction Z2 of board 50. For example, reinforcement plate 70 may be disposed in a range overlapping a central part of second connector 40 in lateral direction Y2 of board 50 and a central part of storage medium 60 in lateral direction Y2 of board 50.

Reinforcement plate 70 is a thin plate-like member having rigidity, for example. Reinforcement plate 70 is fixed to board 50 with a screw, for example. Reinforcement plate 70 is made of a material such as glass epoxy resin, for example.

### (Buffer member)

Buffer member 80 is disposed on second surface 52 at a position overlapping second connector 40 as viewed in thickness direction Z2 of board 50.

For example, buffer member 80 is disposed on second surface 52 of second part 56 as illustrated in Fig. 7. That is, board 50 is bent with second part 56 including second surface 52 disposed on buffer member 80. In this case, buffer member 80 may be disposed while being interposed between reinforcement plate 70 and second surface 52 of second part 56, for example. Buffer member 80 may be disposed on second surface 52 of fourth part 58. In this case, buffer member 80 may be disposed while being interposed between reinforcement plate 70 and second surface 52 of fourth part 58. Buffer member 80 may be also disposed while being interposed between reinforcement plate 70 and second surface 52 of fourth part 58, and between reinforcement plate 70 and second surface 52 of second part 56. Buffer member 80 is fixed to second part 56, reinforcement plate 70, or fourth part 58 with an adhesive, for example.

Buffer member 80 may be also disposed in a range wider than a range overlapping second connector 40 as viewed in thickness direction Z2 of board 50. Buffer member 80 may be disposed in at least a part of the range overlapping second connector 40 as viewed in thickness direction Z2 of board 50. For example, buffer member 80 may be disposed on a stripe in the range overlapping second connector 40, or may be disposed in an interspersed manner in the range.

Buffer member 80 is an elastic member. Buffer member 80 is made of a material such as rubber, or sponge, for example.

### (Operation)

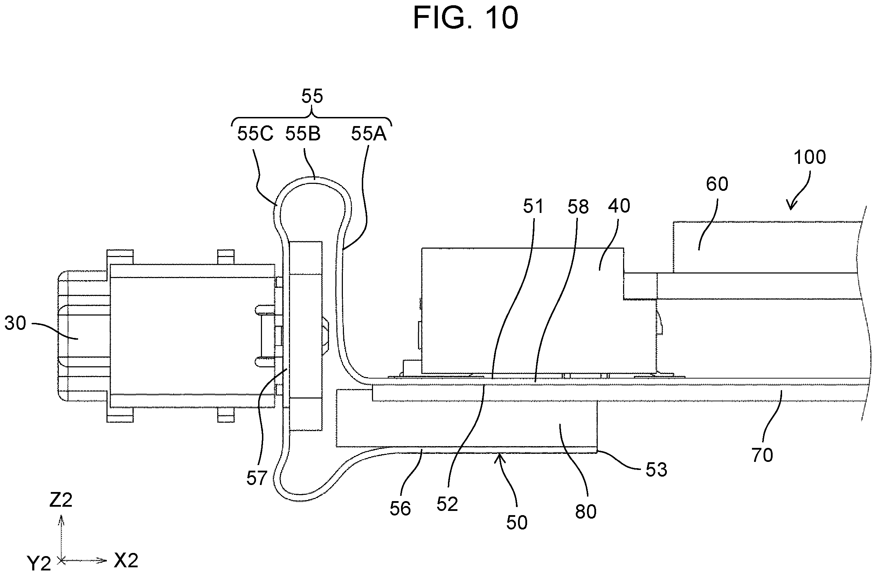

Fig. 10 is a diagram illustrating operation of storage medium module 100 when storage medium module 100 is attached to electronic device 1.

When storage medium module 100 is inserted into module storage part 10 of electronic device 1 along longitudinal direction X2 (or width direction X1 of electronic device 1), first guide part 16A of module connection terminal 13 is housed in second guide part 34 of first connector 30. Then, storage medium module 100 is guided. When storage medium module 100 is further inserted into module storage part 10, module connection terminal 13 is inserted into first connector 30, and then storage medium module 100 is attached to electronic device 1. For example, third part 57 at this time is bent in a direction from first connector 30 toward second connector 40 in length direction X2 of board 50 as illustrated in Fig. 10. Then, first part 55 of board 50 changes in curved shape. The change in curved shape reduces stress applied to first connector 30 when storage medium module 100 is attached to electronic device 1, and thus reduces a force caused by the stress and to be transmitted to second connector 40. After that, board 50 returns to its original shape.

When storage medium module 100 attached to electronic device 1 is pulled in a direction in which storage medium module 100 is detached from module storage part 10 of electronic device 1 along longitudinal direction X2, third part 57 of board 50 is bent in length direction X2 from second connector 40 toward first connector 30, for example. Then, first part 55 of board 50 changes in curved shape. After that, board 50 returns to its original shape.

When an external force is applied to storage medium module 100 other than when storage medium module 100 is attached to or detached from electronic device 1 as described above, first part 55 can change in curved shape. Examples of the external force applied to storage medium module 100 include a force applied from electronic device 1 to storage medium module 100 when electronic device 1 to which storage medium module 100 is attached is dropped. The examples also include a force applied to storage medium module 100 from the outside when storage medium module 100 detached from electronic device 1 is dropped.

### (Effects)

Storage medium module 100 configured as described above includes first connector 30 that is detachably connected to the electronic device, and first part 55 that is curved. This configuration enables storage medium module 100 to be detachably attached to electronic device 1. Additionally, storage medium module 100 can be detached from electronic device 1 and stored. When storage medium module 100 is attached to or detached from electronic device 1, first part 55 changes in curved shape. The change in curved shape enables first part 55 to partly absorb a force loaded on storage medium module 100 via first connector 30. As a result, storage medium module 100 is prevented from being damaged. Examples of the damage to storage medium module 100 include damage to storage medium module 100 itself. The examples also include peeling of second connector 40 from board 50 due to a force transmitted to second connector 40 via first connector 30 and first part 55. The examples further include damage to storage medium 60 caused by a force transmitted to storage medium 60 and included in a force transmitted to second connector 40.

Storage medium module 100 configured as described above enables first part 55 to partly absorb a force that is loaded from electronic device 1 to storage medium module 100 when electronic device 1 to which storage medium module 100 is attached is dropped, for example. In particular, when a force along longitudinal direction X2 of board 50 is loaded on storage medium module 100, first part 55 can absorb the force. Specifically, the change in curved shape of first part 55 having flexibility absorbs partly the force. As a result, storage medium module 100 is prevented from being damaged.

Storage medium module 100 configured as described above enables first part 55 to partly absorb a force that is applied from the outside to storage medium module 100 when storage medium module 100 detached from electronic device 1 is dropped, for example. For example, when a force along longitudinal direction X2 of board 50 is loaded on storage medium module 100 by dropping storage medium module 100 with first connector 30 facing downward, first part 55 can absorb the force. Specifically, the change in curved shape of first part 55 having flexibility absorbs partly the force. As a result, storage medium module 100 is prevented from being damaged.

Storage medium module 100 configured as described above enables buffer member 80 to absorb a force applied from second surface 52 to second connector 40 in thickness direction Z2 of board 50.

When a force is applied from electronic device 1 to storage medium module 100 by dropping electronic device 1 to which storage medium module 100 is attached, for example, buffer member 80 can partly absorb the force. In particular, buffer member 80 can absorb a force applied in thickness direction Z2 of board 50 from electronic device 1 to board 50 via module housing 20. As a result, storage medium module 100 is prevented from being damaged.

Additionally, when a force is applied to storage medium module 100 by dropping storage medium module 100 detached from electronic device 1, for example, buffer member 80 can partly absorb the force. In particular, buffer member 80 can absorb a force applied in thickness direction Z2 of board 50 from electronic device 1 to board 50 via module housing 20. As a result, storage medium module 100 is prevented from being damaged.

Storage medium module 100 configured as described above includes the wiring for transmitting the high-speed signal that is provided on first surface 51 of first part 55, and the first high-speed signal pin 31 that has a distance from second connector 40, the distance being shorter than a distance from second connector 40 to first low-speed signal pin 32. This configuration enables storage medium module 100 to shorten a transmission distance of a high-speed signal, and thus enables securing high transmission performance of the high-speed signal.

Storage medium module 100 configured as described above includes reinforcement plate 70 on second surface 52 of board 50 having flexibility at a position overlapping second connector 40 and storage medium 60 as viewed in thickness direction Z2 of board 50. This configuration enables storage medium module 100 to stably hold second connector 40 and storage medium 60.

Storage medium module 100 configured as described above allows board 50 having flexibility to be supported by module housing 20. This configuration enables storage medium module 100 to be easily attached to or detached from electronic device 1.

Storage medium module 100 configured as described above is detachable from electronic device using first connector 30. As a result, storage medium 60 can be stored separately from electronic device 1. This configuration further enables a plurality of electronic devices 1 to share information using storage medium module 100. Additionally, this configuration enables one electronic device 1 to process data stored in each of a plurality of storage media 60 using storage medium module 100.

Storage medium module 100 configured as described above enables rubber to be used as a material of buffer member 80. As a result, storage medium module 100 can be reduced in manufacturing cost. Additionally, when storage medium module 100 is disposed, for example, buffer member 80 can be reused for other devices and other uses.

Although the present disclosure has been fully described with reference to preferred exemplary embodiments and with reference to the accompanying drawings, various variations and modifications will become apparent to those skilled in the art. Such variations and modifications are to be understood as being included within the scope of the present disclosure as set forth in the appended scope of claims unless departing from the scope of the present disclosure.

### INDUSTRIAL APPLICABILITY

The storage medium module of the present disclosure is applied to an electronic device (such as a laptop PC or a tablet PC) because the storage medium can be safely stored.

### REFERENCE MARKS IN THE DRAWINGS

1: electronic device
2: first housing
3: second housing
3A: side surface
4: display
5: keyboard
6: touch pad
7: hinge part
10: module storage part
11: opening
12A to 12E: first inner wall to fifth inner wall
13: module connection terminal
14: high-speed signal terminal
15: low-speed signal terminal
16: first support member
16A: first guide part
17: lid part
20: module housing
21: opening
22: first module housing
23: second module housing
30: first connector
31: first high-speed signal pin
32: first low-speed signal pin
33: second support member
34: second guide part
40: second connector
41: third support member
50: board
51: first surface
52: second surface
53: first end
54: second end
55: first part
55A: first curved part
55B: second curved part
55C: third curved part
56: second part
57: third part
58: fourth part
60: storage medium
70: reinforcement plate
80: buffer member
100: storage medium module

## Claims

1. A storage medium module comprising:
a board including a first surface and a second surface opposite to the first surface;
a first connector mounted on the first surface of the board and detachably connected to an electronic device; and
a second connector mounted on the first surface separately from the first connector in a longitudinal direction of the board and connected to a storage medium,
the board including a first part extending between the first connector and the second connector and having flexibility, and
the first part being curved.

2. The storage medium module according to claim 1, further comprising a buffer member disposed on the second surface and at a position overlapping the second connector when viewed from a thickness direction of the board.

3. The storage medium module according to claim 2, wherein
the board includes a first end and a second end facing each other in the longitudinal direction,
the first connector and the second connector are each disposed apart from the first end and the second end,
the second connector is disposed at a position closer to the second end than the first connector,
the board includes a second part extending between the first end and the first connector,
at least a part of the first part and at least a part of the second part are disposed at respective positions overlapping each other as viewed in the thickness direction of the board, and
the board is bent with the second part including the second surface disposed on the buffer member.

4. The storage medium module according to any one of claims 1 to 3, wherein the first surface of the first part is provided with wiring for transmitting a high-speed signal.

5. The storage medium module according to any one of claims 1 to 4, wherein the first connector includes a low-speed signal pin and a high-speed signal pin disposed at a position closer to the second connector than the low-speed signal pin.

6. The storage medium module according to any one of claims 1 to 5, wherein
the board is a flexible printed circuit board,
the storage medium module further comprising a reinforcement plate disposed on the second surface at a position overlapping the storage medium and the second connector when viewed from the thickness direction of the board.

7. The storage medium module according to any one of claims 1 to 6, wherein
the longitudinal direction of the board is a direction in which the storage medium module is detachable from the electronic device, and
the first part is curved in the thickness direction of the board.

8. The storage medium module according to any one of claims 1 to 7, wherein
the first part includes:
a first curved part curved in a direction from the second surface toward the first surface;
a second curved part connected to the first curved part and curved in a direction from the second connector toward the first connector; and
a third curved part connected to the second curved part and curved in a direction from the first surface toward the second surface.

9. The storage medium module according to any one of claims 1 to 8, further comprising a module housing that supports the board.

10. An electronic device comprising:
the storage medium module according to any one of claims 1 to 9; and
a module connection terminal connected to the first connector of the storage medium module.
